# EUROPEAN PATENT APPLICATION

(11) **EP 4 439 641 A1**
(43) Date of publication of application: **02.10.2024**
(21) Application number: 23216038.2
(22) Date of filing: 12.12.2023
(51) Int. Cl.: H01L 21/768, H01L 21/02

(54) **PLASMA ENHANCED ATOMIC LAYER DEPOSITION OF DIELECTRIC MATERIAL UPON OXIDIZABLE MATERIAL**

(30) Priority: 31.03.2023 US 202318129704
(71) Applicant: Intel Corporation, Santa Clara, CA 95054 (US)
(72) Inventor: NARIMANNEZHAD, Alireza, Hillsboro, 97124 (US); KAMYSBAYEV, Vladislav, Hillsboro, 97124 (US); QIN, Xiaoye, Portland, 97229 (US); FERDOUS, Sunzida, Portland, 97209 (US); PATEL, Reken, Portland, 97203 (US)
(74) Representative: 2SPL Patentanwälte PartG mbB

(57) **Abstract**

A low-leakage oxide dielectric material with high elastic modulus is deposited directly upon an oxidizable feature with a polycyclic PE-ALD process that limits the formation of an oxide on the feature. A precursor of one or more constituents, such as silicon, may be deposited upon a workpiece during a deposition phase, and the absorbed precursor(s) may be oxidized during a first oxidation phase under more conservative conditions until a first film thickness is achieved. Subsequently, absorbed precursor(s) may be oxidized during a second oxidation phase under more aggressive conditions to arrive at a total film thickness. Transistor contact metal, which may provide local interconnection between source or drain terminals of multiple transistors, may maintain high electrical conductivity after being electrically insulated with such a low-leakage film.

## Description

### BACKGROUND

Fabrication of integrated circuits (ICs) often includes the formation of various electrically active structures, for example comprising some form of metallization or semiconductor. Structures may, for example, function as terminals of a device, such as a transistor, make ohmic contact to such device terminals, and/or electrically interconnect many such devices into a functional circuit. Dielectric material may electrically insulate each active feature from other active features. Improving the electrical performance of the discussed active structure and the dielectric material is an ongoing concern in IC fabrication.

Techniques for forming high quality, low-leakage oxide dielectric films that mitigate issues related to parasitic losses in the active features and other concerns, and IC structures formed according to such techniques, would therefore be commercially advantageous in the IC industry.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is an isometric illustration of an IC portion following PE-ALD of SiOₓ in direct contact with an oxidized portion of an underlying feature, in accordance with some embodiments;
FIG. 2 is a flow diagram illustrating methods of depositing a low-leakage dielectric material, in accordance with some embodiments;
FIG. 3 is an isometric illustration of an IC portion including a low-leakage dielectric material in direct contact with an underlying metallization feaure, in accordance with some embodiments;
FIG. 4 is a flow diagram illustrating a polycyclic PE-ALD deposition method, in accordance with some embodiments;
FIG. 5 is an isometric illustration of an IC portion comprising transistor structures, in accordance with some embodiments;
FIGS. 6A and 6B are cross-sectional views of the transistor structures shown in FIG. 5, in accordance with some embodiments;
FIG. 7 is an isometric illustration of an IC portion comprising transistor structures following polycyclic PE-ALD of a low-leakage oxide dielectric in direct contact with underlying features, in accordance with some embodiments;
FIGS. 8A, 8B and 8C are cross-sectional views of the transistor structures shown in FIG. 7, in accordance with some embodiments;
FIG. 9 is an isometric illustration of an IC portion comprising transistor structures following formation of via metallization, in accordance with some embodiments;
FIGS. 10A and 10B are cross-sectional views of the transistor structures shown in FIG. 9, in accordance with some embodiments;
FIG. 11 is a flow diagram illustrating a polycyclic PE-ALD deposition method, in accordance with some alternative embodiments;
FIGS. 12A and 12B are cross-sectional views of transistor structures, in accordance with some alternative embodiments;
FIGS. 13A and 13B are plots illustrating comparisons of electrical parameters of associated with metal features covered by different SiOₓ films;
FIG. 14 illustrates a system employing an IC including low-leakage SiOₓ in direct contact with a metal feature, in accordance with some embodiments; and
FIG. 15 is a functional block diagram illustrating an electronic computing device, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

Described herein are integrated circuit (IC) structures comprising an oxidizable feature insulated, at least in part, with a high-quality oxide dielectric material that exhibits low electrical leakage (e.g., <1e-9 A/cm²) and high elastic modulus (e.g., > 40 GPa). In exemplary embodiments, the oxidizable feature is a metal feature of a transistor structure (e.g., a source or drain contact metal feature), which may further interconnect source and/or drain terminals of multiple transistors. The oxide dielectric material is advantageously formed with PE-ALD process comprising a plasma-enhanced oxidation phase, which can advantageously achieve lower leakage and larger elastic modulus than is possible with alternative deposition techniques, such as PECVD. The inventors have found that surface oxidation of an oxidizable feature exposed to PE-ALD can be greatly reduced, or completely avoided, through the practice of a polycyclic PE-ALD process in accordance with embodiments herein.

Exemplary polycyclic PE-ALD of oxide dielectrics comprises at least two different cycles, each of which may be iterated or cycled any number of times. In a first cycle, a precursor of one or more constituents, such as silicon, may be deposited upon a workpiece during a deposition phase and the absorbed precursor(s) may be oxidized during a first oxidation phase under first conditions, which minimize the oxidation of an underlying feature. As described further below, these first conditions include at least a reduced plasma power. The first cycle may be repeated for a first duration or number of iterations until a first film thickness is attained. In a second cycle, a precursor(s) of one or more constituents, such as silicon, absorbed during a deposition phase are oxidized during a second oxidation phase under second conditions, which maximize the quality of the deposited dielectric material. As described further below, these second conditions include at least a greater plasma power. The second cycle may be repeated for a second duration or number of iterations to arrive at a total film thickness.

As described further below, duration and oxidation conditions of the first cycle may be optimized to obtain a minimum dielectric material thickness that will reduce or prevent oxidation of the underlying sensitive feature by the second cycle. Duration and oxidation conditions of the second cycle may be optimized to achieve very low electrical leakage and/or very high elastic modulus associated with excellent electrical insulator film quality.

Accordingly, in some exemplary transistor structures described further below, contact metal employed as local interconnect routing may be electrically insulated with a low-leakage dielectric film without sacrificing significant electrical conductivity of the metal through its conversion into a more resistive metal oxide.

The flexibility of the polycyclic PE-ALD techniques exemplified herein also facilitate non-planar IC architectures, at least in part, because of the greater conformality of the ALD process relative to other deposition processes. Although exemplary applications described herein are provided primarily in the context of metal features and transistor structures, polycyclic PE-ALD techniques so described may be further applied to any IC structure where an oxidizable feature (e.g., metal or semiconductor material) is to be embedded within a high-quality oxide dielectric material.

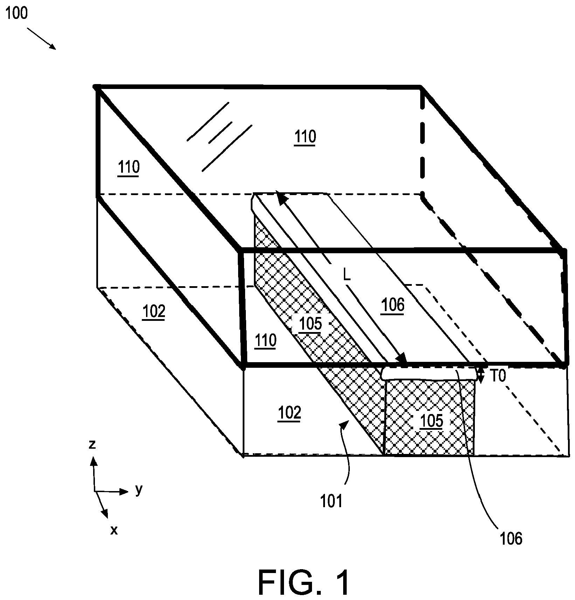

In the example illustrated in FIG. 1, an IC portion 100 includes a line 101. Line 101 may comprise an oxidizable material 105. Oxidizable material 105 may be a metal with a relatively low oxidation activation energy, for example. Line 101 has a longitudinal length L along which an electrical current is to pass during operation of IC portion 100. Dielectric material 102 adjacent to line 101 may electrically insulate line 101 from adjacent structures (not depicted).

After the formation of line 101, another dielectric material 110 may be deposited over line 101 to further insulate line 101 from overlying structures (not depicted). The quality of dielectric materials 102 and 110 impact electrical performance of IC portion 100. For example, relative permittivity of dielectric materials 102 and 110 (i.e., dielectric constant) impacts parasitic capacitance of line 101. As another example, electrical leakage and breakdown voltage of dielectric materials 102 and 110 impacts other parasitic losses associated with IC portion 100.

The quality of dielectric materials 102 and 110 is a function of the deposition technique(s) employed in their formation. Plasma enhanced chemical vapor deposition (PECVD) has long been a technique enlisted in IC fabrication. PECVD energizes a plasma of a precursor, such as tetraethyl orthosilicate (TEOS) to deposit a SiOₓ film, for example. However, dielectric films deposited by PECVD techniques, particularly SiOₓ films, may exhibit a level of electrical leakage that is undesirable for advanced IC applications.

Plasma enhanced atomic layer deposition (PE-ALD) has been found to form dielectric films of higher quality than PECVD. More specifically, PE-ALD SiOₓ films have been found to exhibit significantly lower electrical leakage than PECVD SiOₓ films. However, the inventors have found PE-ALD of an oxide (e.g., SiOₓ) film can oxidize at least a portion of sensitive features exposed to the dielectric deposition process. As shown in FIG. 1, for example, some portion of oxidizable material 105 may be oxidized or converted into an oxide 106 during a PE-ALD of dielectric material 110. For an example where oxidizable material 105 is a metal, oxide 106 is an oxide of the metal. In FIG. 1, oxide 106 is not illustrated at the interface of dielectric material 102 because dielectric material 102 may have been formed prior to the formation of line 101, for example. However, a similar oxide 106 may also form on sidewalls of line 101 for implementations where those sidewalls are also exposed to PE-ALD of an oxide film.

Where oxide 106 has a lower electrical conductivity than oxidizable material 105, the conversion of some portion of oxidizable material 105 into oxide will reduce current carrying cross-sectional area (e.g., z-y plane in FIG. 1) of line 101 as function of oxide thickness T0. As a result, electric resistance of longitudinal length L is increased, decreasing performance of IC portion 100.

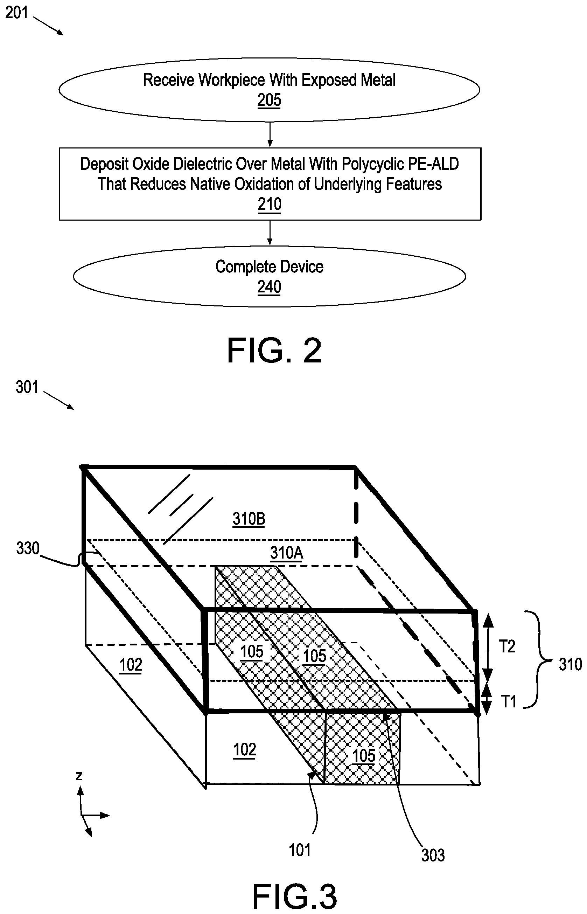

FIG. 2 is a flow diagram illustrating methods 201 for depositing a low-leakage, high modulus dielectric material comprising oxygen, in accordance with some embodiments. Methods 201 begin at block 205 where a workpiece is received. In some examples, the workpiece comprises a 300-450 mm diameter wafer. A working surface of the workpiece comprises one or more oxidizable features. The workpiece may advantageously further include a monocrystalline semiconductor layer, such as a silicon layer, upon which front-end-of-line (FEOL) FETs have been fabricated, for example upstream of methods 201. In some examples, the FEOL FETs include both n-type and p-type FETs that are to be interconnected into a CMOS FEOL circuit with various levels of interconnect metallization features, which may locally connect adjacent transistor terminals and/or globally interconnect circuit nodes spanning an entire area of an IC die. In some embodiments, the oxidizable features exposed on the working surface are local interconnects between adjacent transistors. However, in some alternative embodiments, the workpiece received at block 205 may instead lack any prefabricated transistors or other microelectronic devices and oxidizable features exposed on the working surface are components of any device.

Methods 201 continue at block 210 where a dielectric material comprising oxygen is deposited upon a working surface of the substrate. In accordance with embodiments herein, a polycyclic PE-ALD process is practiced at block 210. In contrast to a monocyclic PE-ALD process, a polycycle process comprises at least two different cycles: a first cycle with a less aggressive plasma-enhanced oxidation phase, and a second cycle with more aggressive plasma-enhanced oxidation phase. The oxidation phase of the first cycle may be optimized to oxidize an exposed feature surface as little as possible. This first cycle may be advantageously performed for the minimum duration or number of iterations that ensure the second cycle will not subsequently oxidize the underlying metal surface. The oxidation phase of the second cycle may be optimized to obtain a dielectric with a lowest electrical leakage and/or highest elastic modulus and/or lowest relative permittivity. The second cycle may be advantageously performed for a maximum duration or number of cycles to ensure the dielectric material will have bulk properties substantially defined by parameters of the second cycle.

In exemplary embodiments, the oxide dielectric material deposited at block 210 is predominantly silicon and oxygen (SiOₓ), although the dielectric material deposited may include other constituents (e.g., C, N, etc.). The dielectric material may include any atomic ratio of constituents to oxygen. For SiOₓ, x may be nearly 2 so that the dielectric material deposited at block 210 is ideally stoichiometric silicon dioxide (SiO₂). However, the ratio need not be stoichiometric and may instead be silicon-rich or silicon-lean.

The dielectric material deposited at block 210 has a high elastic modulus (ε), for example at least exceeding 20 GPa, advantageously exceeding 40 GPa (e.g., 50-60 GPa), and more advantageously exceeding 60 GPa (e.g., 70 GaP, or more). The dielectric material deposited at block 210 advantageously also has a low bulk relative permittivity (e.g., *k* < 5). In exemplary SiOₓ embodiments, the material deposited at block 210 has a bulk relative permittivity of no more than 4.1 and advantageously less than 4.1. These properties of the dielectric material deposited at block 210 may be deduced through one or more analysis techniques, such as electrical device probing (e-test), X-ray reflectometry (XRR), X-ray photoelectron spectroscopy (XPS), energy dispersive spectroscopy (EDS), or electron energy loss spectroscopy (EELS).

Methods 201 end at output 240 where any operations to complete a given device (e.g., IC die) may be practiced. For example, any number of interconnect levels comprising any number of thin film materials may be fabricated to complete a monolithic IC structure.

FIG. 3 is an isometric illustration of an IC portion 301 including a low-leakage dielectric material 310 comprising oxygen, which is in direct contact with underlying line 101 comprising oxidizable material 105, in accordance with some embodiments. Dielectric material 310 may be formed by practicing methods 201 (FIG. 2), for example. Reference numbers employed in FIG. 3 are retained from FIG. 1 where structural and/or material properties are substantially as described for IC portion 301.

Dielectric material 310 comprises two portions demarked by interface 330. A first dielectric material portion 310A of thickness T1 is proximal to the underlying line 101, and in the illustrated example, forms an interface with a top feature surface 303. A second dielectric material portion 310B of thickness T2 is distal to line 101, with the first dielectric material portion 310A between the second dielectric material portion 310B and line 101. In this exemplary structure, dielectric material portion 310A was deposited with a first cycle of a polycyclic PE-ALD process, and dielectric material portion 310B was deposited with a second cycle of the polycyclic PE-ALD process.

In some advantageous embodiments, there is little, if any, difference in chemical composition between dielectric material portions 310A and 310B. As described further below, chemical homogeneity across interface 330 ensures interface 330 will be transparent or invisible to any subsequent etch process performed to pattern dielectric material 310. For example, both portions 310A and 310B may be advantageously predominantly silicon and oxygen (SiOₓ). However, dielectric material portion 310A may have a different relative permittivity, electrical leakage and/or elastic modulus than dielectric material portion 310B. For example, dielectric material portion 310A may have a higher relative permittivity and electrical leakage than dielectric material portion 310B. Dielectric material portion 310A may also have a lower elastic modulus than dielectric material portion 310B. Other material properties may also differ across interface 330 within dielectric material 310.

The two dielectric material portions 310A and 310B may together impart bulk electrical and physical properties that are dominated by those of portion 3 10B, at least in part because thickness T2 is most of the total dielectric material thickness (T2+T1). In exemplary embodiments, thickness T2 is over 50 % of the total thickness of dielectric material 310, advantageously at least 75% of the total thickness of dielectric material 310, and more advantageously 90%, or more, of the total thickness. Thickness T1 is advantageously less than 10 nm, and more advantageously less than 5 nm. However, thickness T1 is non-zero and advantageously at least 2 nm (e.g., 3-4 nm). Hence, for some embodiments where thickness T2 is around 8 times thickness T1, thickness T2 is 200-800 nm.

As illustrated in FIG. 3, dielectric material portion 310A is in direct contact with top feature surface 303. Accordingly, oxidizable material 105 is in direct contact with dielectric material 310. More specifically, there is in this example substantially no oxide between top surface 303 and dielectric material portion 310A. Hence, line 101 has a current carrying cross-sectional area that is unimpeded by any conversion of material 105 into an oxide. Even where oxidizable material 105 has a relatively low oxidation activation energy, dielectric material portion 310A may be in direct contact with material 105 instead there being some intervening oxide. Although the composition of oxidizable material 105 may vary with implementation, in some advantageous embodiments material 105 is predominantly one or more metal. In some specific examples, material 105 is at least one of W, Mo, Co, or Ru or an alloy thereof and there is no intervening layer of WOₓ, MOₓ, CoOₓ, or RuOₓ between dielectric material portion 310A and top surface 303.

Although FIG. 3 illustrates direct contact between dielectric material portion 310A and material 105 at top surface 303, for embodiments where an oxide is present, the thickness of any such oxide layer may be substantially reduced through practice of a polycyclic PE-ALD deposition in accordance with embodiments herein. For examples where material 105 is at least one of W, Mo, Co, or Ru, any intervening layer of WOₓ, MOₓ, CoOₓ, or RuOₓ is less than 2 nm in thickness, which can be optimized to be no more than 1 nm for most any metal.

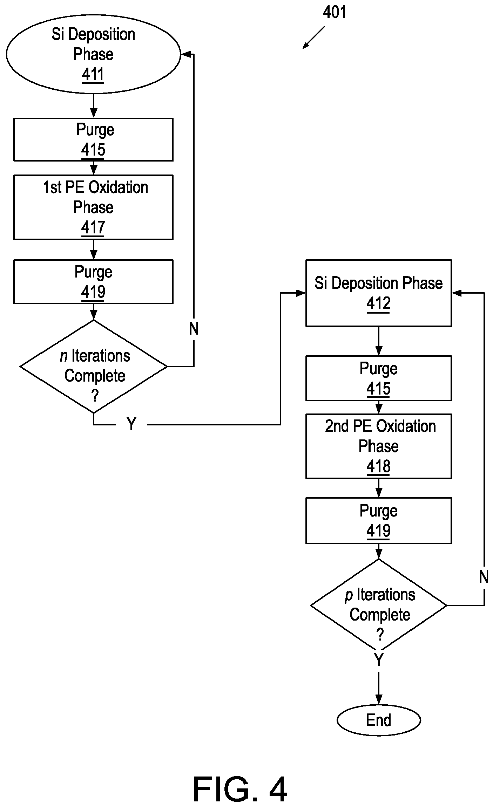

FIG. 4 is a flow diagram illustrating a polycyclic PE-ALD deposition method 401, in accordance with some embodiments. Methods 401 may be practiced at block 210 of methods 201, for example. In exemplary embodiments, methods 401 are performed in one or more PE-ALD chambers. For some exemplary low temperature embodiments, methods 401 are performed at temperatures that do not to exceed 450 °C, and are advantageously less than 400 °C. Internal pressures of the ALD deposition process may be in the range of 1-3 Torr, for example.

The PE-ALD deposition methods 401 entail cyclically depositing a precursor of a dielectric material during a deposition phase of two different ALD cycles and oxidizing the deposited precursor during a different plasma oxidation phase of each of the two cycles. For each of the two cycles, the PE-ALD deposition of dielectric material may be performed a time-divided and/or space-divided manner. Time-divided embodiments may be performed with a workpiece contained within a single environment with conditions of the environment modified over time. Space-divided embodiments may be performed with a workpiece passing through multiple environments, each of environments maintaining distinct condition. Space and time divided embodiments combining these attributes are also possible, for example with a workpiece passing through a plurality of environments and various ones of the plural environments being further modified over time. Ultimately, the number of iterations though each of the cycles determines a thickness of a dielectric material portion deposited by each of the two cycles.

During the first phase of the first cycle, at block 411 a dielectric precursor is introduced into a deposition chamber. In exemplary embodiments, the dielectric precursor comprises silicon suitable for thermal adsorption to a surface of a workpiece. Although many silicon precursors are known, one example is bis(diethylamino) silane. A first chamber purge is then performed at block 415 where a purge gas is supplied to flush away any excess precursor and/or reaction byproducts from the surface of the workpiece and/or the ALD chamber volume.

The first cycle continues at block 417 where an oxygen precursor is introduced into the chamber during a first oxidation phase. The oxygen precursor reacts with the adsorbed dielectric material precursor to form a monolayer of dielectric material (e.g., comprising Si and oxygen). Although the oxygen precursor may vary (e.g., COₓ, NOₓ, etc.), in exemplary embodiments, the oxygen precursor is O₂. One or more inert sources (e.g., Ar, He, etc.) may be introduced at block 417 to improve plasma enhancement. Any number of parameters controlling the plasma oxidation phase may be tuned to moderate the oxidation process. The oxygen precursor is plasma activated, for example by energizing an RF or magnetron source, to output a first power. In exemplary embodiments, the first plasma power is at a relatively low level to minimize the oxidation of atoms in a feature of the workpiece surface to which some of the precursor is absorbed. Following the oxidation phase, the first cycle completes with a second chamber purge at block 419. The purges performed at blocks 415 and 419 may be the same or different, for example employing the same, or different, purge gases, etc.

This first cycle may be repeated any number of n times to attain a target first deposition duration and/or thickness. Hence, methods 401 may iterate through n first cycles before advancing to a second ALD cycle. The second cycle begins at block 412 where a dielectric material precursor is supplied, and the precursor adsorbs to available sites on a surface of the substrate exposed to the dielectric material precursor. In exemplary embodiments, the second dielectric material precursor introduced at block 412 is the same as that introduced at block 411 (e.g., a silicon precursor). At block 415, the purge gas is again supplied to flush away any precursor and/or reaction byproducts from the surface of the workpiece and/or the ALD chamber volume.

The second cycle continues at block 418, where a reactive oxygen (oxidizing) precursor is supplied and the oxygen precursor reacts with the adsorbed dielectric precursor to form a monolayer of dielectric material (e.g., comprising silicon and oxygen). Although the oxygen precursor may vary (e.g., COₓ, NOₓ, etc.), in exemplary embodiments, the oxygen precursor is the same as that introduced as block 417. One or more inert sources (e.g., Ar, He, etc.) may also be introduced. The oxygen precursor is again plasma activated, but this time with parameters that amplify the oxidation process. In exemplary embodiments, at least the plasma power is increased to a relatively high second output power, which is significantly higher than the first output power enlisted at block 417. In advantageous embodiments, this second plasma power is at least four times that of the first plasma power. The second plasma power may, in some alternative embodiments, be at least eight times that of the first plasma power as higher plasma power has been found to improve the quality of the dielectric material (e.g., SiOₓ).

At block 419, a purge gas is again supplied to flush away any excess oxygen precursor and/or reaction byproducts from the surface of the workpiece and/or the ALD chamber volume. The blocks 412, 415, 418 and 419 may each be performed once as a second ALD cycle forming additional dielectric material. At the higher plasma powers, both electrical leakage and relatively permittivity of the dielectric material formed during the second cycle will be significantly lower and the elastic modulus significantly greater. Any number *p* of the second cycles may be performed to achieve a total thickness of dielectric material. Methods 201 may therefore again iterate through *p* cycles before method 401 is terminated. In methods 401, the ratio of *n:p* may be approximately equal to a desired ratio of the thicknesses between a first dielectric material portion formed by the first cycle and a second dielectric material portion formed by the second cycle.

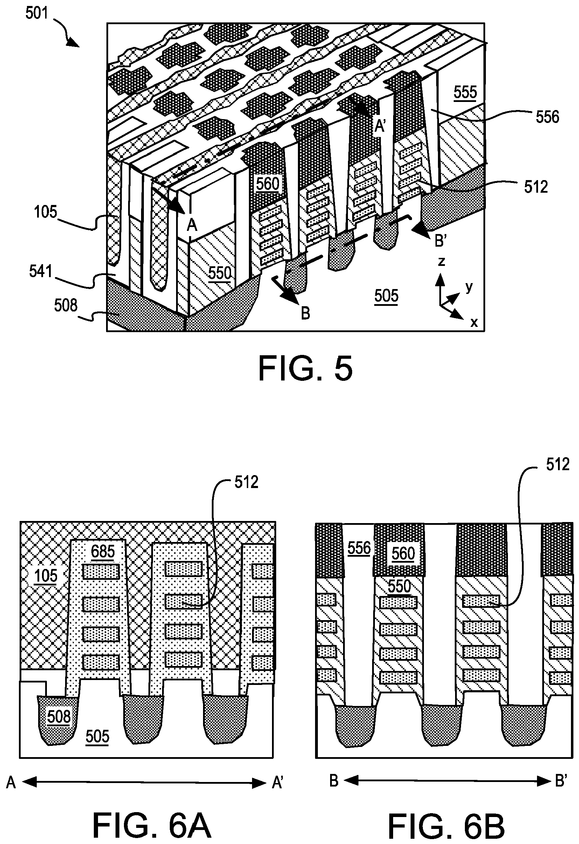

As previously noted, the above techniques for polycyclic PE-ALD of dielectric materials may be applied to a wide variety of IC architectures. FIG. 5 is an isometric illustration of an IC portion 501 comprising stacked nanoribbon transistor structures, in accordance with some advantageous embodiments. FIG. 6A illustrate cross-sectional views of the transistor structures along the A-A' and B-B' lines shown in FIG. 5, respectively.

IC portion 501 includes a mask material 560 over a stack of nanoribbon channel material layers 512 over a substrate material 505, which may be monocrystalline (e.g., silicon) in some embodiments. Each nanoribbon transistor structure is separated by an isolation dielectric material 508. Mask material 560 may have any composition known to be suitable as a hardmask for patterning a channel material stack. In some examples, mask material 560 is a dielectric material, such as silicon oxide (SiO), silicon nitride (SiN), silicon oxynitride, (SiON).

Channel material layers 512 may each have any composition suitable for a channel of a field effect transistor (FET). In some examples, at least one channel material layer 512 is substantially silicon. In some embodiments, at least one channel material layer 512 comprises germanium (e.g., Si₁₋ₓGe_{X}, Ge₁₋ₓSn_{X}, or substantially pure Ge). In some embodiments, a channel material layer 512 includes a transition metal and a chalcogen. The transition metal may be any transition metal such as any element of groups 4 through 11, the group 3 elements scandium and yttrium, and the inner transition metals (e.g., f-block lanthanide and actinide series). Notable transition metals are molybdenum and tungsten. The chalcogen may be sulfur, selenium, and tellurium. In still other embodiments, a channel material layer 512 comprises one or more metals and oxygen (i.e., metal oxide semiconductor), such as, but not limited to, Indium, gallium zinc oxide (IGZO).

Each channel material layer 512 is advantageously crystalline. Although the crystalline semiconductor includes polycrystalline thin film material, a channel material layer 512 may be substantially monocrystalline. In some embodiments where a channel material layer 512 is substantially pure silicon, the crystallinity of the channel material layer 512 is cubic with a top surface having crystallographic orientation of (100), (111), or (110), for example. Other crystallographic orientations are also possible. Channel material layers 512 may also be polycrystalline or amorphous, for example in certain metal chalcogen and/or metal oxide embodiments.

As further illustrated in FIG. 5, a gate spacer material 541 is adjacent to a sidewall of a gate material 550. Gate spacer material 541 may be deposited by any process and then planarized with a top surface of mask material 560, for example. Although a gate spacer may have any composition, in exemplary embodiments spacer material 541 is a dielectric. Advantageously, spacer material 541 has a different chemical composition than that of mask material 560. Gate material 550 occupies a region between adjacent spacer material 541. As shown, gate material 550 is between one channel material layer 512 of a stack and another channel material layer 512 of the same stack. Any gate insulator material (not depicted), such as a high-k (e.g., k>9) dielectric material including oxygen and one or more metals (e.g., HfOₓ), may be between the channel material layers 512 and gate material 550.

Gate material 550 may have any composition. In some embodiments, gate material 550 includes a work function metal and a fill metal. Gate material 550 may be deposited and planarized with a surface of mask material 560 and/or spacer material 541. Following planarization, gate material 550 may be recessed with any suitable gate etch process to expose sidewalls of mask material 560. Additional dielectric material 555 and 556 may be deposited around each transistor structure and over gate material 550.

As shown in FIG. 5, the A-A' cross-section line extends in the y-dimension, running parallel to longitudinal line length of oxidizable material 105. Hence, in this embodiment a line comprising oxidizable material 105 spans multiple transistors. As further illustrated in FIG. 6A, oxidizable material 105 is in direct contact with a source or drain material 685, which is further coupled to an end of channel material layers 512. Source or drain material 685 is impurity-doped to be either p-type or n-type. Source and drain material 685 is advantageously epitaxial to the channel material layers 512. Oxidizable material 105 may have any composition suitable for making ohmic or Schottky electrical contact with source or drain material 685. In some exemplary embodiments, oxidizable material 105 comprises a non-cuprous metal, such as W, Mo, Co, or Ru, or an alloy thereof.

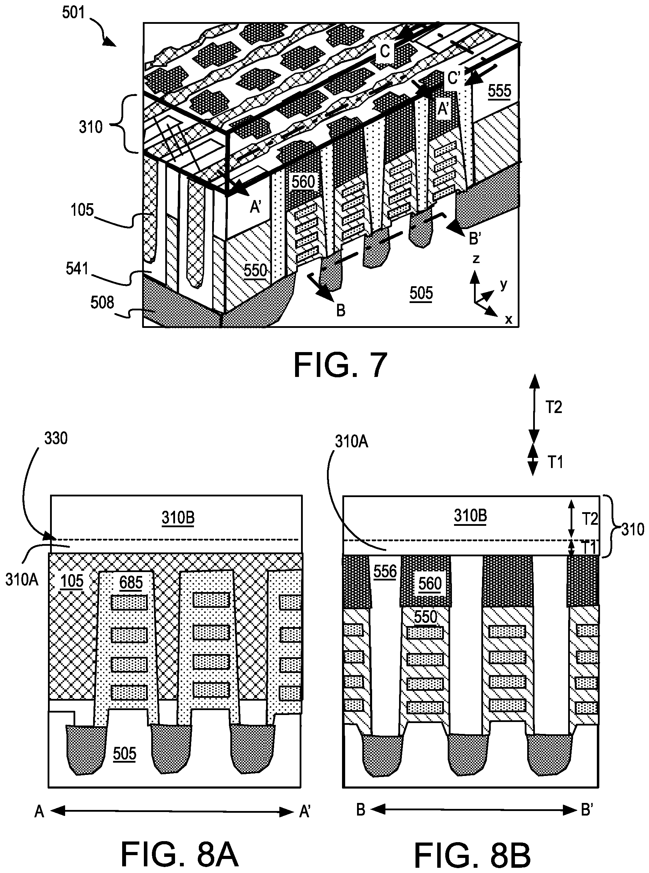

FIG. 7 further illustrates IC portion 501 following deposition of dielectric material 310, which has any (or all) of the properties described above (e.g., in the context of FIG.3). Dielectric material 310 is therefore in direct contact with metal 105 in substantially the same manner described above. Dielectric material 310 is advantageously a low-leakage, high modulus SiOₓ, as described above. In exemplary embodiments, there is essentially no oxide of material 105 between dielectric material 310 and material 105. If an oxide layer is present, it is advantageously less than 1 nm in thickness (e.g., z-dimension).

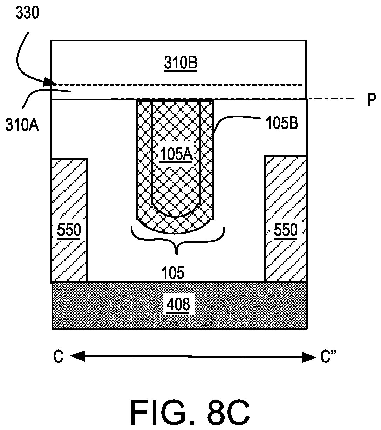

FIG 8A, 8B and 8C are cross-sectional views of the transistor structures shown in FIG. 7, along the A-A', B-B' and C-C' lines, respectively. As shown in FIG. 8A, dielectric material portion 310A of thickness T1 is in direct contact with a top surface of oxidizable material 105. Dielectric material portion 310B of thickness T2 is over dielectric material portion 310A. In FIG. 8b, dielectric material portion 310A of thickness T1 is in direct contact with underlying mask material 560 and dielectric material 556.

FIG. 8C illustrates cross-sectional view of metal 105 within the C-C' cross-sectional plane that runs perpendicular to the A-A' and B-B' planes. In this example, oxidizable material 105 is shown to further include a fill material 105A and a liner material 105B in contact with a sidewall of fill material 105A. Fill material 105A may have a first chemical composition (e.g., a first metal such as one of W, Mo, Co, or Ru or first alloy thereof), while liner metal 105B has a second chemical composition (e.g., a second metal such as one of W, Mo, Co, or Ru or second alloy thereof). Notably, even where the first and second compositions have significantly different oxidation activation energies, dielectric material portion 310A forms an interface with fill material 105A that is substantially co-planar with the interface with liner material 105B. Such co-planarity (along plane P in FIG. 8C) indicates the deposition of dielectric material portion 310A converted essentially none of either fill material 105A or liner material 105B into a (e.g., metal) oxide. Accordingly, material 105 retains as much cross-sectional area as possible for maximum line conductance (minimum resistance) for a given topology.

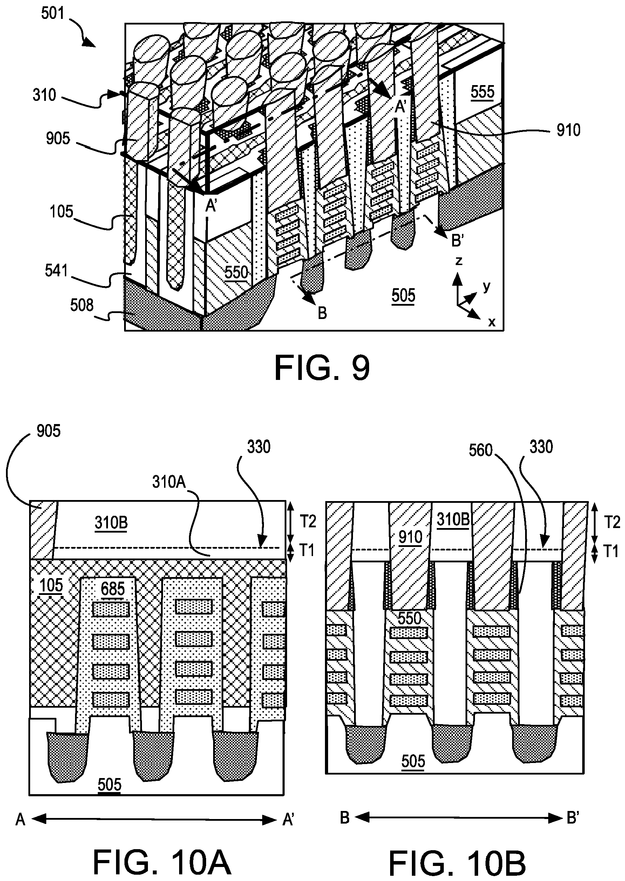

FIG. 9 is an isometric illustration of IC portion 501 following formation of via metallization, in accordance with some embodiments. FIG 10A and 10B are cross-sectional views of the transistor structures shown in FIG. 9 along the A-A' and B-B' lines, respectively. As shown, a source or drain via metallization 905 passes through dielectric material 310 and is in direct contact with material 105. In exemplary embodiments where the chemical composition of dielectric material portions 310A and 310B is substantially the same, an etch process to form a source or drain via opening through dielectric material 310 may rely on a single step to pass through both thickness T2 and thickness T1 with no etch stop occurring at interface 330 (FIG. 10A). Similarly, as shown in FIG. 10B, a gate via metallization 910 passes through dielectric material 310, dielectric mask 560, and is in direct contact with gate material 550. An etch process forming a gate via opening through dielectric material 310 may rely on a single step to pass through both thickness T2 and thickness T1. The same step, or another step, may be employed to etch through mask material 560. Hence, the practice of a polycyclic PE-ALD process to form dielectric material 310 in accordance with embodiments herein is independent of, and transparent to, downstream via etch processes.

As noted above, a polycyclic PE-ALD process may be practiced to deposit SiOₓ with minimal oxidation of an underlying sensitive material, such as a metal. A polycyclic PE-ALD process may also be practiced to deposit other dielectric materials posing a similar propensity to convert an underlying sensitive material into any another less-desirable material. Furthermore, a polycyclic PE-ALD process may include more than two cycles, for example where a compositional change within a dielectric material is acceptable.

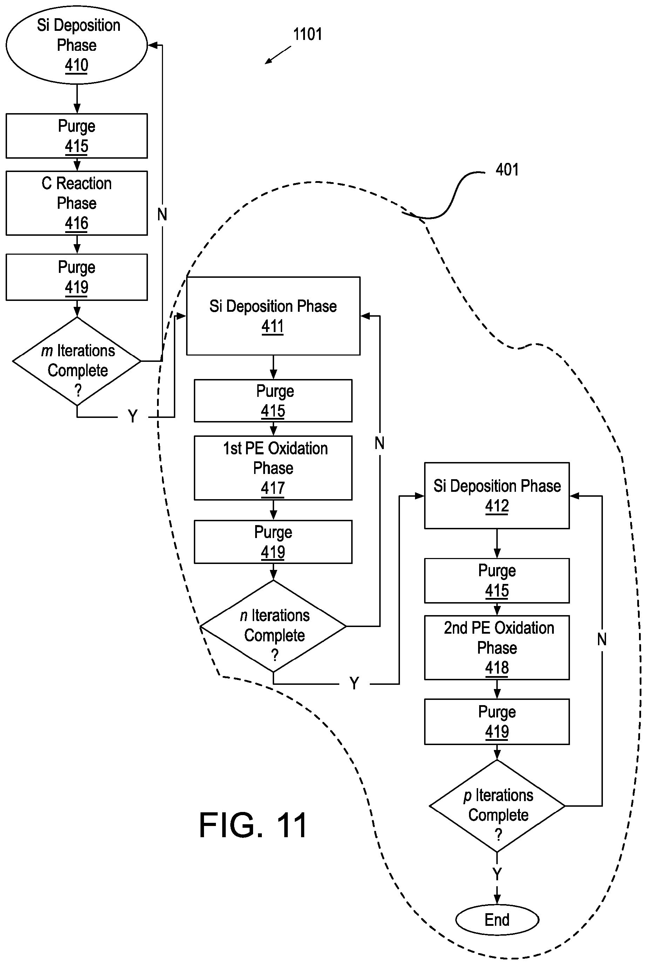

FIG. 11 is a flow diagram illustrating a polycyclic ALD deposition method, in accordance with some alternative embodiments where a silicon carbide is first deposited over an underlayer that is sensitive to oxidation. The underlayer is free of any threat of oxidation during deposition of the silicon carbide, which is deposited to a minimal thickness that is advantageously completely converted into SiOₓC_{y} during a subsequent cycle that includes a plasma oxidation phase. This plasma oxidation phase is advantageously a gentle oxidation, which is to just convert the entire thickness of SiC deposited by the first cycle without affecting the underlying material. A final cycle with a more aggressive plasma oxidation phase is then performed to reach a desired bulk dielectric material thickness.

As shown in FIG. 11, method 1101 therefore includes method 401, which is preceded by a cycle that begins with a silicon deposition phase at input 411. Following a purge 415, a carbon reaction phase is performed at block 416 by introducing any suitable precursor, such as carbontetrachloride (CCl₄) or trichloromethane (CHCl₃). A second purge at block 419 is again performed and any number of *m* first cycles may be practiced forming a desired thickness of SiC. In exemplary embodiments, upon depositing no more than 1 nm of SiC, methods 1101 continue with the further practice of methods 401 where SiOₓ is deposited in a subsequent cycle including low plasma enhanced oxidation phase at block 417. In exemplary embodiments, a low power plasma at block 417 is selected to fully oxidize the SiC layer over *n* cycles performed as part of methods 1101. The sacrificial conversion of SiC into SiOₓC_{y} inhibits oxidation of sensitive material (e.g., a metal) underlying the SiOₓC_{y}. Methods 1101 complete with *p* iterations of a final deposition cycle where highest quality SiOₓ is deposited with an aggressive (e.g., higher power) plasma enhanced oxidation phase at block 419 to reach a target total thickness (e.g., 20 nm).

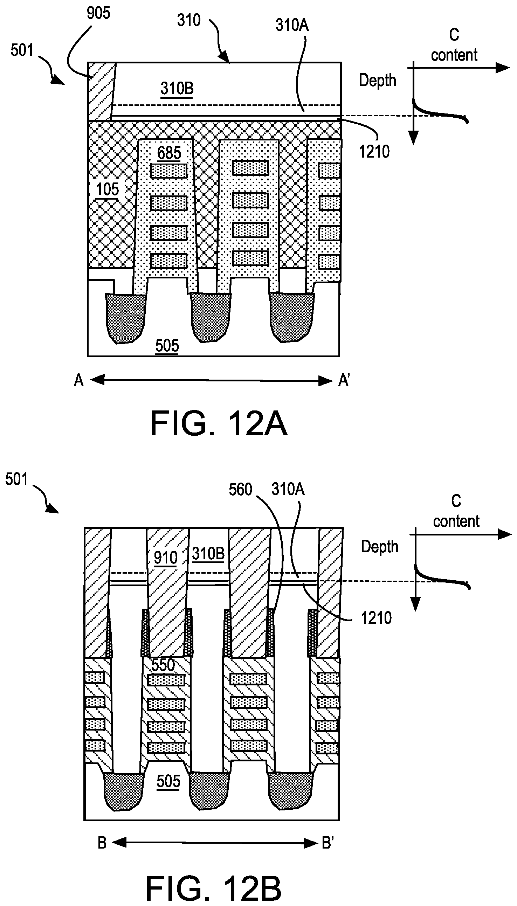

FIG. 12A and 12B are cross-sectional views of transistor structures for IC portion 501 along the A-A' and B-B' lines, in accordance with some alternative embodiments where methods 1101 (FIG. 11) are practiced. As shown, dielectric material 310 is formed over a compositionally distinct interfacial dielectric material layer 1210 demarked by a solid line. Having been formed with a SiC deposition cycle, dielectric material layer 1210 comprises carbon in addition to silicon and oxygen (i.e., SiOₓC_{y}). Dielectric material layer 1210 advantageously has a thickness of no more than 1 nm and is in direct contact with oxidizable material 105. Dielectric material portion 310A is in direct contact with dielectric material layer 1210 and an oxidation phase performed during a SiO_{X} deposition cycle has completely oxidized material layer 1210. As also illustrated, compositional analysis techniques may show an increase in carbon content proximal (e.g., within 2 nm) to the interface with material 105, which is indicative of a polycyclic ALD process similar to that of methods 1101.

In FIG. 12A and 12B, source or drain via metallization 905 passes through dielectric material 310 and also dielectric material layer 1210. Since the chemical composition of dielectric material 1210 is different from that of portions 310A and 310B, an etch process to form a source or drain via opening contacting material 105 may employ multiple steps. Similarly, a gate via metallization 910 passing through dielectric material 310, dielectric material 12010, and dielectric mask 560 may require a multi-step etch process.

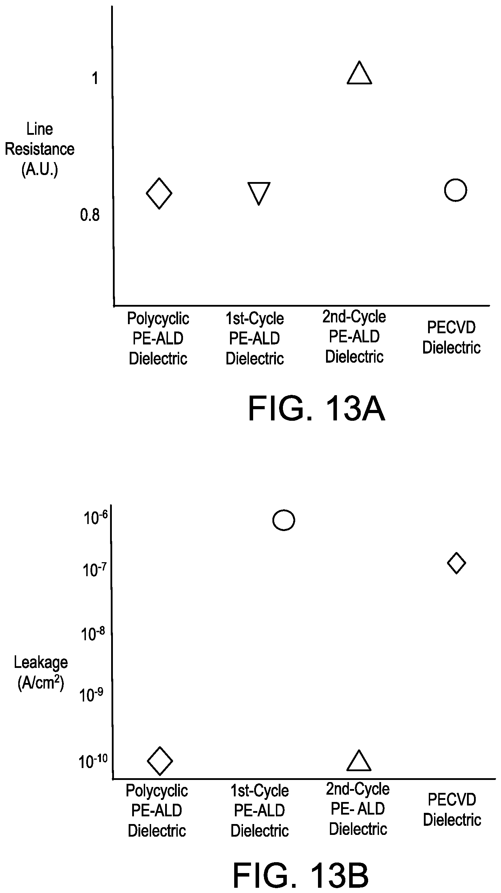

As noted above, the inventors have found conductive features covered with a high-quality oxide dielectric to exhibit superior electrical performance relative to reference structures having an oxide or covered with a lower quality oxide dielectric. FIG. 13A is graph illustrating low line resistance of a metal line covered by SiOₓ deposited in accordance with some polycyclic PE-ALD embodiments. As shown, metal line resistance is highest if SiOₓ is deposited on the metal line with a monocyclic PE-ALD process, which, for example, includes only the second cycle of the PE-ALD process illustrated in FIG. 4. The reference resistance level is attributable, in part, to the formation of a native metal oxide upon a portion of the metal exposed to the SiO_{X} deposition. A similar metal line exhibits 15-20% lower resistance for a monocyclic PE-ALD process, which, for example, includes only the first cycle of the PE-ALD process illustrated in FIG. 4. The lower resistance is attributable to the absence of any native metal oxide.

As further depicted in FIG. 13A, a similar metal line exhibits substantially the same lower resistance for a polycyclic PE-ALD process including both the first and second cycles illustrated in FIG. 4. Hence, the practice of the first cycle prevents the second cycle from resulting in the higher line resistance seen if only the second cycle is performed. FIG. 13A further illustrates resistance of a similar line covered with a PECVD SiO_{X} is like that of the polycyclic PE-ALD treatment.

FIG. 13B is graph comparing electrical leakage of SiOₓ deposited in accordance with some polycyclic PE-ALD embodiments with other deposition treatments. The leakage values were collected for films with substantially the same thickness (e.g., approximately 20nm) that were subjected an electric field strength of 11MV/cm. However, the same trend is evident at lesser fields (e.g., both 2 MV/cm and 4 MV/cm). As shown, dielectric leakage is high (e.g., > 1e-6 A/cm²) for a treatment where SiOₓ is deposited with a monocyclic PE-ALD process that includes only the first cycle of the PE-ALD process illustrated in FIG. 4. This leakage level is also associated with a relatively low elastic modulus and higher relative permittivity of the SiOₓ. A high electrical leakage exceeding 1e-8 A/cm² (e.g., 5e-7 A/cm² - 5e-6 A/cm²) is similarly found for SiOₓ is deposited with a reference PECVD process.

Electrical leakage is significantly lower (e.g., 1e-10 A/cm² to 1e-9 A/cm²) for a monocyclic PE-ALD process that includes only the second cycle of the PE-ALD process illustrated in FIG. 4. The lower leakage is also associated with a relatively high elastic modulus and lower relative permittivity of the SiOₓ. As further depicted in FIG. 13B, SiOₓ deposited with a polycyclic PE-ALD process including both the first and second cycles illustrated in FIG. 4 also exhibits low electrical leakage (e.g., 1e-10 A/cm² to 1e-9 A/cm²). This lower leakage is again associated with a relatively high elastic modulus and lower relative permittivity of the SiOₓ. Hence, the practice of the second cycle avoids the higher electrical leakage seen if only the first cycle is performed. Accordingly, the SiOₓ deposited with a polycyclic PE-ALD retains the film quality attributes that make it superior to a PECVD SiO_{X}.

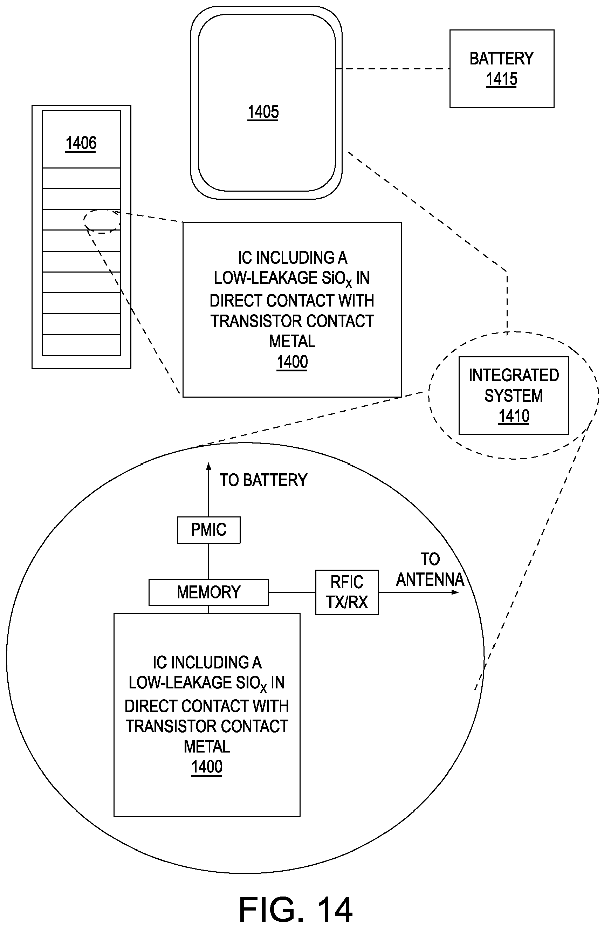

The deposition techniques and resulting structures described above may be employed in a wide range of IC devices and further integrated in a wide range of computer-based applications. FIG. 14 illustrates a mobile computing platform 1405 and a server machine 1406 employing a packaged IC die including a low-leakage SiOₓ in contact with a transistor contact metal, for example as described elsewhere herein. Server machine 1406 may be any commercial server, for example including any number of high-performance computing platforms disposed within a rack and networked together for electronic data processing, which in the exemplary embodiment includes a packaged IC die comprising including a low-leakage SiOₓ in contact with a transistor contact metal, for example as described elsewhere herein.

The mobile computing platform 1405 may be any portable device configured for each of electronic data display, electronic data processing, wireless electronic data transmission, or the like. For example, the mobile computing platform 1405 may be any of a tablet, a smart phone, laptop computer, etc., and may include a display screen (e.g., a capacitive, inductive, resistive, or optical touchscreen), an integrated system 1410, and a battery 1415.

As illustrated in the expanded view, one or more of a power management integrated circuit (PMIC) or RF (wireless) integrated circuit (RFIC) including a wideband RF (wireless) transmitter and/or receiver may be further coupled to IC 1400. A PMIC may perform battery power regulation, DC-to-DC conversion, etc., and so has an input coupled to battery 1415 and an output providing a current supply to other functional modules. An RFIC may have an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G and beyond.

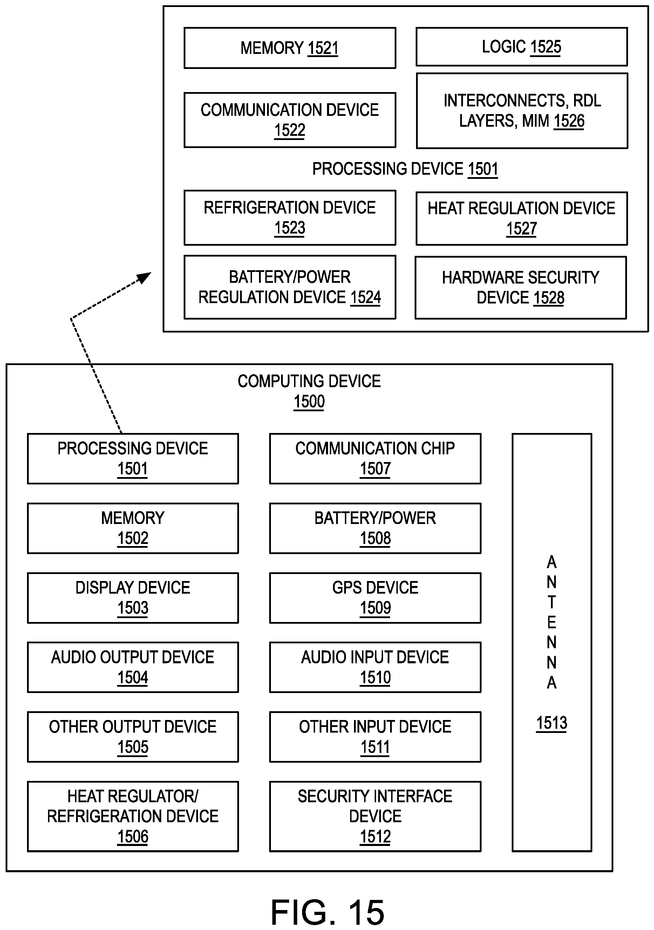

FIG. 15 is a block diagram of a cryogenically cooled computing device 1500 in accordance with some embodiments. For example, one or more components of computing device 1500 may include any of the low-leakage SiOₓ materials discussed elsewhere herein. A number of components are illustrated in FIG. 15 as included in computing device 1500, but any one or more of these components may be omitted or duplicated, as suitable for the application. In some embodiments, some or all of the components included in computing device 1500 may be attached to one or more printed circuit boards (e.g., a motherboard). In some embodiments, various ones of these components may be fabricated onto a single system-on-a-chip (SoC) die. Additionally, in various embodiments, computing device 1500 may not include one or more of the components illustrated in FIG. 15, but computing device 1500 may include interface circuitry for coupling to the one or more components. For example, computing device 1500 may not include a display device 1503, but may include display device interface circuitry (e.g., a connector and driver circuitry) to which display device 1503 may be coupled.

Computing device 1500 may include a processing device 1501 (e.g., one or more processing devices). As used herein, the term processing device or processor indicates a device that processes electronic data from registers and/or memory to transform that electronic data into other electronic data that may be stored in registers and/or memory. Processing device 1501 may include a memory 1521, a communication device 1522, a refrigeration/active cooling device 1523, a battery/power regulation device 1524, logic 1525, interconnects 1526 (i.e., optionally including redistribution layers (RDL) or metal-insulator-metal (MIM) devices), a heat regulation device 1527, and a hardware security device 1528.

Processing device 1501 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 1501 may include a memory 1502, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1521 includes memory that shares a die with processing device 1501. This memory may be used as cache memory and may include embedded dynamic random-access memory (eDRAM) or spin transfer torque magnetic random-access memory (STT-M RAM).

Computing device 1500 may include a heat regulation/refrigeration device 1506. Heat regulation/refrigeration device 1506 may maintain processing device 1501 (and/or other components of computing device 1500) at a predetermined low temperature during operation. This predetermined low temperature may be any temperature discussed elsewhere herein.

In some embodiments, computing device 1500 may include a communication chip 1507 (e.g., one or more communication chips). For example, the communication chip 1507 may be configured for managing wireless communications for the transfer of data to and from computing device 1500. The term "wireless" and its derivatives may be used to describe circuits, devices, systems, methods, techniques, communications channels, etc., that may communicate data through the use of modulated electromagnetic radiation through a nonsolid medium.

Communication chip 1507 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1507 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1507 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1507 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1507 may operate in accordance with other wireless protocols in other embodiments. Computing device 1500 may include an antenna 1513 to facilitate wireless communications and/or to receive other wireless communications (such as AM or FM radio transmissions).

In some embodiments, communication chip 1507 may manage wired communications, such as electrical, optical, or any other suitable communication protocols (e.g., the Ethernet). As noted above, communication chip 1507 may include multiple communication chips. For instance, a first communication chip 1507 may be dedicated to shorter-range wireless communications such as Wi-Fi or Bluetooth, and a second communication chip 1507 may be dedicated to longer-range wireless communications such as GPS, EDGE, GPRS, CDMA, WiMAX, LTE, EV-DO, or others. In some embodiments, a first communication chip 1507 may be dedicated to wireless communications, and a second communication chip 1507 may be dedicated to wired communications.

Computing device 1500 may include battery/power circuitry 1508. Battery/power circuitry 1508 may include one or more energy storage devices (e.g., batteries or capacitors) and/or circuitry for coupling components of computing device 1500 to an energy source separate from computing device 1500 (e.g., AC line power).

Computing device 1500 may include a display device 1503 (or corresponding interface circuitry, as discussed above). Display device 1503 may include any visual indicators, such as a heads-up display, a computer monitor, a projector, a touchscreen display, a liquid crystal display (LCD), a light-emitting diode display, or a flat panel display, for example.

Computing device 1500 may include an audio output device 1504 (or corresponding interface circuitry, as discussed above). Audio output device 1504 may include any device that generates an audible indicator, such as speakers, headsets, or earbuds, for example.

Computing device 1500 may include an audio input device 1510 (or corresponding interface circuitry, as discussed above). Audio input device 1510 may include any device that generates a signal representative of a sound, such as microphones, microphone arrays, or digital instruments (e.g., instruments having a musical instrument digital interface (MIDI) output).

Computing device 1500 may include a global positioning system (GPS) device 1509 (or corresponding interface circuitry, as discussed above). GPS device 1509 may be in communication with a satellite-based system and may receive a location of computing device 1500, as known in the art.

Computing device 1500 may include another output device 1505 (or corresponding interface circuitry, as discussed above). Examples include an audio codec, a video codec, a printer, a wired or wireless transmitter for providing information to other devices, or an additional storage device.

Computing device 1500 may include another input device 1511 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1500 may include a security interface device 1512. Security interface device 1512 may include any device that provides security measures for computing device 1500 such as intrusion detection, biometric validation, security encode or decode, managing access lists, malware detection, or spyware detection. In some examples, security interface device 1512 comprises OTP ROM further including a via MIM fuse, for example as described elsewhere herein.

Computing device 1500, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the disclosure is not limited to the embodiments described above and can instead be practiced with modification and alteration without departing from the scope of the appended claims. For example, the above embodiments may include specific combinations of features as further provided below.

In first examples, an apparatus comprises a transistor comprising a source, a drain and a gate, a metal in direct contact with the source or drain, and a dielectric material comprising predominantly silicon and oxygen over the metal. The dielectric material is in direct contact with a top surface of the metal, or is separated from the top surface by no more than 1nm of an intervening oxide of the metal. The dielectric material has an electrical leakage less than 1e-9 A/cm² at an electric field of 11 MV/cm.

In second examples, for any of the first examples the dielectric material has an elastic modulus of at least 40 GPa.

In third examples, for any of the second examples the elastic modulus is at least 60 GPa.

In fourth examples, for any of the first through third examples the dielectric material has a relative permittivity less than 4.1.

In fifth examples, for any of the first through fourth examples the dielectric material has a thickness over the metal and a carbon concentration of the dielectric material is highest within 1nm of the thickness nearest to the metal.

In sixth examples, for any of the fifth examples carbon is substantially absent from the dielectric material beyond 2 nm of the thickness nearest to the metal.

In seventh examples, for any of the first through sixth examples the metal is a first metal, a second metal is in contact with a sidewall of the first metal, and an interface between the dielectric material and a top surface of the first metal is co-planar with an interface between the dielectric material and a top surface of the second metal.

In eighth examples, for any of the seventh examples the first metal is W and the second metal is Mo.

In ninth examples, an integrated circuit (IC) structure, comprises a feature of metal. A top surface of the metal comprises predominantly one or more of W, Mo, Co, or Ru or an alloy thereof. A dielectric material comprising predominantly silicon and oxygen is over the feature. The dielectric material has an elastic modulus of at least 40 GPa and is in direct contact with the metal, or is separated from the metal by no more than 1nm of an intervening oxide of the metal.

In tenth examples, for any of the ninth examples the dielectric material has an electrical leakage less than 1e-9 A/cm² at an electric field of 11 MV/cm.

In eleventh examples, for any of the ninth or tenth examples the dielectric material has a relative permittivity less than 4.1.

In twelfth examples, for any of the ninth through eleventh examples the feature of metal comprises at least one of W and Mo.

In thirteenth examples, for any of the ninth through twelfth examples the feature of metal is in direct contact with a source or drain of a first transistor. The feature of metal is in direct contact with a source or drain of a second transistor. The feature spans a space between the first transistor and the second transistor. A via extends through the thickness of the dielectric material and is in direct contact with the metal feature.

In fourteenth examples a method comprises receiving a workpiece, the workpiece having a surface comprising a metal. The method comprises depositing on the workpiece a first thickness of a dielectric material comprising predominantly silicon and oxygen with a first ALD cycle comprising a plasma enhance oxidation phase having a first power. The method comprises depositing, over the first thickness, a second thickness of the dielectric material comprising predominantly silicon and oxygen with a second ALD cycle comprising a plasma enhance oxidation phase having a second power, greater than the first power.

In fifteenth examples, for any of the fourteenth examples the second power is at least 5 times greater than the first power.

In sixteenth examples, for any of the fifteenth examples the second power is at least 10 time greater than the first power.

In seventeenth examples, for any of the fourteenth through sixteenth examples the first ALD cycle is performed for a first time and the second ALD cycle is performed for a second time, longer than the first time.

In eighteenth examples, for any of the seventeenth examples the second time is at least four times longer than the first time.

In nineteenth examples, for any of the fourteenth through eighteenth examples the method comprises depositing on the workpiece an interface layer comprising silicon and carbon, and the first ALD cycle oxidizes the interface layer into the dielectric material.

In twentieth examples, for any of the nineteenth examples the interface layer is deposited to a thickness less than 1.5 nm.

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the disclosure should, therefore, be determined with reference to the appended claims, along with the full scope of equivalents to which such claims are entitled.

## Claims

1. An apparatus comprising:
a transistor comprising a source, a drain and a gate;
a metal in direct contact with the source or drain; and
a dielectric material comprising predominantly silicon and oxygen over the metal, wherein the dielectric material is in direct contact with a top surface of the metal, or is separated from the top surface by no more than 1nm of an intervening oxide of the metal, and wherein the dielectric material has an electrical leakage less than 1e-9 A/cm² at an electric field of 11 MV/cm.

2. The apparatus of claim 1, wherein the dielectric material has an elastic modulus of at least 40 GPa.

3. The apparatus of claim 2, wherein the elastic modulus is at least 60 GPa.

4. The apparatus of any one of claims 1-3, wherein the dielectric material has a relative permittivity less than 4.1.

5. The apparatus of any one of claims 1-4, wherein the dielectric material has a thickness over the metal and a carbon concentration of the dielectric material is highest within 1nm of the thickness nearest to the metal.

6. The apparatus of any one of claims 1-5, wherein carbon is substantially absent from the dielectric material beyond 2 nm of the thickness nearest to the metal.

7. The apparatus of any one of claims 1-6, wherein:
the metal is a first metal;
a second metal is in contact with a sidewall of the first metal; and
an interface between the dielectric material and a top surface of the first metal is co-planar with an interface between the dielectric material and a top surface of the second metal.

8. The apparatus of claim 7, wherein the first metal is W and the second metal is Mo.

9. An integrated circuit (IC) structure, comprising:
a feature of metal, wherein a top surface of the metal comprises predominantly one or more of W, Mo, Co, or Ru or an alloy thereof; and
a dielectric material comprising predominantly silicon and oxygen over the feature, wherein the dielectric material is in direct contact with the metal, or is separated from the metal by no more than 1nm of an intervening oxide of the metal, and wherein the dielectric material has an elastic modulus of at least 40 GPa.

10. The IC structure of claim 9, wherein the dielectric material has an electrical leakage less than 1e-9 A/cm² at an electric field of 11 MV/cm.

11. The IC structure of any one of claims 9-10, wherein the dielectric material has a relative permittivity less than 4.1.

12. The IC structure of any one of claims 9-11, wherein the feature of metal comprises at least one of W and Mo.

13. The IC structure of any one of claims 9-12, wherein the feature of metal is in direct contact with a source or drain of a first transistor, wherein the feature of metal is in direct contact with a source or drain of a second transistor, wherein the feature spans a space between the first transistor and the second transistor, and wherein a via extends through the thickness of the dielectric material and is in direct contact with the metal feature.

14. A method comprising:
receiving a workpiece, the workpiece having a surface comprising a metal;
depositing on the workpiece a first thickness of a dielectric material comprising predominantly silicon and oxygen with a first ALD cycle comprising a plasma enhance oxidation phase having a first power;
depositing, over the first thickness, a second thickness of the dielectric material comprising predominantly silicon and oxygen with a second ALD cycle comprising a plasma enhance oxidation phase having a second power, greater than the first power.

15. The method of claim 14, wherein the second power is at least 5 times greater than the first power; wherein the first ALD cycle is performed for a first time, and wherein the second ALD cycle is performed for a second time that is at least four times longer than the first time.
